(19) Europäisches Patentamt
European Patent Office
Office européen des brevets

(11) **EP 0 478 577 B1**

(12) **EUROPEAN PATENT SPECIFICATION**

(45) Date of publication and mention
of the grant of the patent:
**13.03.1996 Bulletin 1996/11**

(51) Int Cl.6: **H01L 29/78**, H01L 29/34,
H01L 21/265, H01L 21/465

(21) Application number: **90907873.5**

(22) Date of filing: **08.05.1990**

(86) International application number:
**PCT/US90/02555**

(87) International publication number:
**WO 90/16085 (27.12.1990 Gazette 1990/29)**

(54) **APPARATUS AND METHOD FOR A DUAL THICKNESS DIELECTRIC FLOATING GATE MEMORY CELL**

APPARAT UND VERFAHREN ZUR HERSTELLUNG EINER SPEICHERZELLE MIT SCHWEBENDEM GATE UND DOPPELTER DIELEKTRIKUMSCHICHT

APPAREIL ET PROCEDE DE FABRICATION D'UNE CELLULE DE MEMOIRE A ELECTRODE DE GRILLE FLOTTANTE A DIELECTRIQUE ET A DOUBLE EPAISSEUR

(84) Designated Contracting States:
**AT BE CH DE DK ES FR GB IT LI LU NL SE**

(30) Priority: **21.06.1989 US 369134**

(43) Date of publication of application:
**08.04.1992 Bulletin 1992/15**

(73) Proprietor: **XICOR, INC**
**Milpitas California 95035 (US)**

(72) Inventor: **GUTERMAN, Daniel, Charles**
**Fremont, CA 94539 (US)**

(74) Representative: **Bowles, Sharon Margaret et al**
**BOWLES HORTON**
**Felden House**
**Dower Mews**
**High Street**
**Berkhamsted Hertfordshire HP4 2BL (GB)**

(56) References cited:
EP-A- 0 228 761          GB-A- 2 073 484
JP-A- 0 196 950          JP-A- 5 933 873
JP-A- 6 367 783          US-A- 4 203 158
US-A- 4 274 012          US-A- 4 462 090
US-A- 4 486 769          US-A- 4 706 102
US-A- 4 794 433

• PATENT ABSTRACTS OF JAPAN, vol. 10, no.
137 (E-405)(2194) 21 May 1986 ; & JP-A-61 001
056

**Description**

Field of the Invention

The present invention relates generally to nonvolatile memory cells and more particularly to a memory cell having a dielectric layer with two different thicknesses formed between two conducting layers and wherein field emission tunneling is caused to occur through the lesser dielectric thickness.

Background of the Invention

Integrated circuit memory devices have been developed which store data for indefinite periods of time and which also have the capability of selectively changing the data stored. Of particular interest here is a nonvolatile memory device which utilizes a memory cell which is completely surrounded by a relatively thick insulating material or dielectric and is thus termed a "floating gate". Nonvolatile memory cells may be arranged, as is known in the art, to construct nonvolatile random access memories (NOVRAMs) and electrically erasable programmable read-only memories (EEPROMs). U.S. Patent No 4,300,212 and U.S. Patent No. 4,486,769, for example, disclose a NOVRAM and an EEPROM, respectively.

Some EEPROMs made with the so called "thin oxide" technology utilize relatively thin layers of insulating silicon dioxide with two different thicknesses. However, EEPROMs made with this technology have a region of ultra thin (80 to 150 Angstroms) dielectric through which bi-directional tunneling occurs between a smooth single crystal surface and a polysilicon layer.

The fabrication of a memory cell typically consists of depositing and patterning layers of polysilicon with layers of insulating oxide in between. Patterning may be done using conventional photolithographic techniques well known in the industry. More specifically, first polysilicon layer is formed and patterned on a first dielectric layer formed on silicon substrate. A second dielectric layer is then formed to completely surround the first polysilicon layer and to form a tunneling oxide on the surface of the first polysilicon layer. A second polysilicon layer is formed and patterned on top of the second dielectric layer. A third dielectric layer is formed on the second polysilicon layer such that the second polysilicon layer is completely surrounded by dielectric. A third polysilicon layer is then formed and patterned on top of the third dielectric layer. Finally, a fourth dielectric layer is deposited over the entire memory cell.

Typically, the first polysilicon layer is a programming electrode, the second polysilicon layer is the floating gate, and the third polysilicon layer is an erase electrode. The floating gate generally lies between the programming electrode and the erase electrode and partially overlies the former and is itself partially overlain by the latter. Beneath and insulated from the floating gate is the substrate. In one configuration, there is an electrically isolated bias electrode disposed in the substrate of opposite conductivity to the substrate. This bias electrode forms one plate of a coupling capacitor to the floating gate and is also referred to as a metallurgical "paddle". In another configuration there is no metallurgical paddle disposed in the substrate.

Programming, erasing, and retaining information on the floating gate is achieved by controlling the flow of electrons to and from the floating gate. Since the polysilicon layers are insulated from each other by the layers of oxide, the electrons must "tunnel" either from the programming electrode to the floating gate or from the floating gate to the erase electrode. The electron tunneling is controlled by the relative potentials between the electrodes and the floating gate.

The floating gate voltage operating window is defined to be the difference between the positive potential on the floating gate when the floating gate has been erased and the level of negative potential on the floating gate when the floating gate has been programmed. Favorable operating conditions are obtained when this operating window is large and remains large. As the device is alternately programmed and erased, the size of the operating window decreases, thereby shortening the remaining usable lifetime of the device. Thus, a continuing objective of floating gate devices is to increase the operating window size and to maintain that increased window size for a greater number of program and erase cycles, thereby increasing the useful lifetime of the device.

A generally desirable objective of most semiconductor devices is miniaturization. As devices become smaller, however, any misalignment of the polysilicon layers will produce changes in the capacitance between the layers which adversely affects the operation of the device.

Accordingly, it is an object of the present invention to provide a memory cell which reduces alignment sensitivity between polysilicon layers by forming a second thicker dielectric layer between the polysilicon layers in all areas except for those regions where tunneling is to occur.

It is a further object of the present invention to provide a memory cell having less sensitivity to variations in alignment or dimensions of various cell elements (linewidths) thereby providing an improved floating gate memory cell operating window over a wide range of processing variations.

## Summary of the Invention

US patent 4,274,012 shows a floating gate memory cell with alternate conducting layers spaced by a dielectric layer through which tunelling occurs. The surfaces of the programming and floating gate conducting layers are provided with aspherictes, i.e. small projections at the surface, which reduce the field strength necessary for tunelling by providing localised high field at a lower average field strength. Similar subject-matter is dislosed in US-A-4 486 769 and US-A-4 706 102.

Accordingly the present invention provides a semiconductor integrated circuit device having first and second conducting layers separated by a dielectic layer, said first conducting layer having a surface including at least one region of localized curvature which enhances the electric field locally such that the application of a potential difference between said first and second conducting layers will cause enhanced field emission tunneling of electrons to occur from said first conducting layer through said dielectric layer to said second conducting layer; <u>characterised in that</u> said dielectric layer includes first and second portions formed on said surface of said first conducting layer, the first portion adjacent said region of localized curvature and having a first thickness and the second portion having a second, relatively greater, thickness, such that said enhanced field emission tunneling is caused to occur primarily through said first portion of said dielectric layer from said first conducting layer to said second conducting layer.

The present invention also provides a method for forming a semiconductor integrated circuit device, comprising the steps of (a) forming a first conducting layer on an underlying first insulating layer; (b) forming regions of enhanced field emission on said first conducting layer; (c) forming a second insulating layer of a predetermined thickness on the exposed surfaces of said first conducting layer; (d) forming a masking layer having a predetermined pattern on a top surface of said second insulating layer thereby forming a pattern in said second insulating layer so as to expose predetermined regions of said first conducting layer; (e) under-cutting said second insulating layer by an etching process a predetermined amount interior to the edge boundaries of said masking layer; (f) etching said first conducting layer according to said predetermined pattern defined by said masking layer; (g) forming a third insulating layer on all exposed surfaces, such that a resultant insulating layer on top of said first conducting layer has first and second regions of different predetermined thicknesses; and (h) forming a second conducting layer over said resultant insulating layer.

In a preferred embodiment the device comprises a method according to any preceding claim in which the device comprises a floating gate semiconductor memory device, the first insulating layer is a gate oxide layer of predetermined thickness formed on top of a semiconductor substrate, the first conducting layer is formed of polysilicon and the regions of enhanced field emission comprise a microtextured surface, the second insulating layer is an interpoly oxide layer formed relatively thickly on the polysilicon surface, the etching of the interpoly oxide layer and the polysilicon layer in steps (e) and (f) exposes corner portions of the polysilicon layer over which the third insulating layer is deposited, the third insulating layer being formed relatively thinly as a tunneling oxide and the second conducting layer also comprises polysilicon.

## Brief Description of the Drawings

Figure 1 is a schematic cross-sectional view of a dual thickness interpoly oxide floating gate nonvolatile memory cell according to the present invention.

Figure 2 is a schematic of an equivalent circuit describing the operation a floating gate nonvolatile memory cell according to the present invention.

Figures 3(a) and 3(b) are schematic cross-sectional views of aligned mirrored memory cells according to the present invention and misaligned mirrored memory cells, respectively.

Figures 4(a) to 4(f) are schematic cross-sectional views of a process to form a dual thickness dielectric layer according to the present invention.

Figures 5(a) to 5(d) illustrate an example of the improvement to the floating gate memory window according to the present invention.

## Detailed Description of the Invention

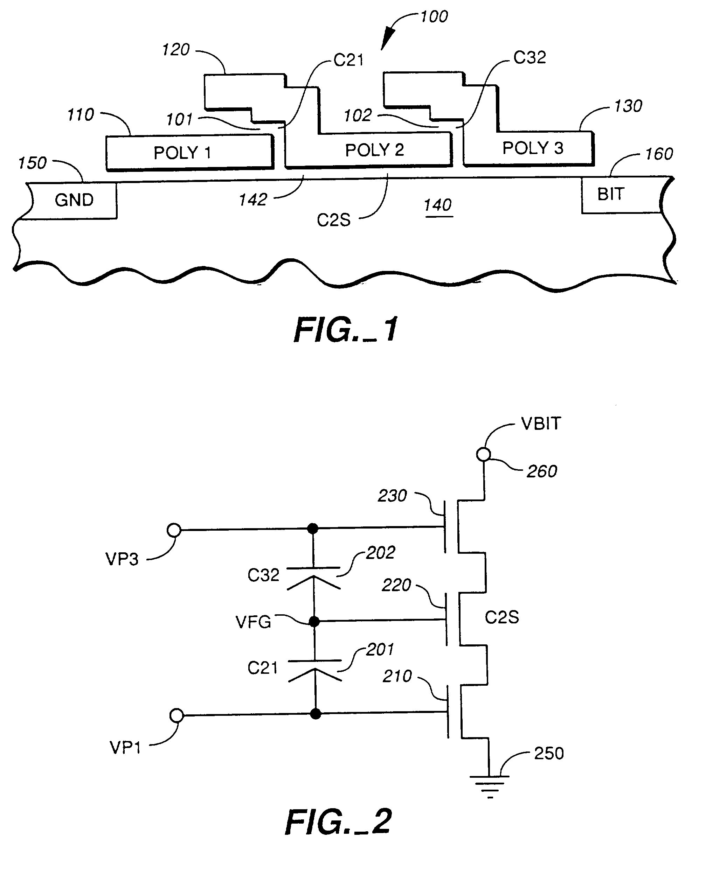

A schematic cross-sectional view of a dual thickness interpoly oxide as applied to a paddleless floating gate nonvolatile memory cell according to the present invention is shown in Figure 1 at 100. A programming electrode 110 is formed from a first polysilicon layer (poly 1), a floating gate 120 is formed from a second polysilicon layer (poly 2), and an erase electrode 130 is formed from a third polysilicon layer (poly 3). The layers are separated from each other and from substrate 140 by layers of dielectric material such as silicon dioxide. The portion of the dielectric layer between the floating gate 120 and the programming electrode 110 is a tunneling element 101 and the portion of dielectric between the erase electrode 130 and the lower portion of the floating gate 120 is a tunneling element 102. The capacitances of tunneling elements 101 and 102 are denoted by $C_{21}$ and $C_{32}$, respectively. The capacitance between floating gate 120 and substrate 140 is denoted by $c_{2S}$ (the "steering capacitance"). A ground terminal 150 is disposed in substrate 140 proximate programming electrode 110 and a bit line terminal 160 is disposed in substrate 140 proximate erase electrode 130.

By suitably treating the conducting layers, the surfaces of the floating gate and the programming electrode are microtextured to produce curved surfaces which enhance the electric field locally. This local field enhancement creates the high fields necessary to cause Fowler-Nordheim field emission tunneling with relatively low voltages applied across the tunneling dielectric. For example, a 1000 angstrom silicon dioxide layer grown on a polished single crystal substrate typically tunnels when 80 - 100 volts is applied across it. A similar 1000 angstrom oxide formed on textured polysilicon typically tunnels when only 10 to 20 volts is applied across the oxide. It is this field enhancement due to the localized curvature or microtexturing of the surface of the polysilicon layer that allows a relatively thick dielectric layer to be used in the present invention. These locally curved or microtextured regions may be formed on the top surface or edge surfaces of the polysilicon layers depending on the type of processes, including oxidation, following the polysilicon deposition. The amount of curvature or microtexturing is adjusted through the ensuing processes to set the desired voltage at which tunneling occurs.

An equivalent circuit describing the memory cell of Figure 1 is shown in Figure 2. The potentials of the polysilicon layers are given by $V_{P1}$ (for poly 1), $V_{FG}$ (for the poly 2 floating gate), and $V_{P3}$ (for poly 3). The tunneling elements are shown schematically as 201 and 202. The poly layers each form the gates of a field effect transistor with poly 3 forming the gate of a transistor 230, poly 2 forming the gate of transistor 220, and poly 1 forming the gate of transistor 210. The channel regions of these transistors 210, 220, and 230 are formed within the surface 142 of substrate 140 (as shown in Figure 1). The bit line voltage $V_{BIT}$ 260, ground 250, and capacitances $C_{21}$, $C_{32}$, and $C_{2S}$ are also shown.

The floating gate voltage operating window (also known as the memory window) is defined to be the difference between the positive potential on the floating gate when the floating gate has been erased and the level of negative potential on the floating gate when the floating gate has been programmed. Based on Figure 2, the floating gate voltage after writing may be approximately expressed as:

$$V_{FG} = (V_{FG})P, E + \frac{\sum_j C_j V_j}{\sum_j C_j} \tag{1}$$

where

$$(V_{FG})_P = \frac{C_{21} - C_{32}}{C_{21} + C_{32}} \cdot \frac{V_{P3} - V_{P1}}{2} \tag{2}$$

for the programmed state, and

$$(V_{FG})_E = \frac{C_{21} - C_{32}}{C_{21} + C_{32} + C_2 S} \cdot \frac{V_{P3} - V_{P1}}{2} + \frac{C_2 S}{C_{21} + C_{32} + C_2 S} \cdot \frac{V_{P3} + V_{P1}}{2} \tag{3}$$

for the erased state where $(V_{FG})_E$ is the erase state floating gate voltage and $(V_{FG})_P$ is the program state floating gate voltage and where $V_{P1}$ and $V_{P3}$ are the potentials used during the write operation. The summation over j in Equation (1) extends over the parasitic capacitances that are "seen" by the floating gate and can be cut off at any desired number depending on significance of the terms. A typical value for j is 6. Equations (2) and (3) are derived considering only the capacitance terms shown, assuming all other capacitances are sufficiently small to be ignored. The steering capacitance $C_{2S}$ for this paddleless case is assumed to have the full metallurgical capacitance value of the floating gate to the substrate for the programmed state and to approach zero for the erased state. These conditions are further assumed to hold for both write and read operations. The tunneling voltages (voltages across the tunneling elements necessary to maintain the required tunneling currents during write operations) are assumed to be equal and of a value that is half of the total voltage applied between poly 3 and poly 1 during a write operation.

A memory cell with a paddle typically has a bias electrode disposed in, and of opposite conductivity to, the substrate region beneath the floating gate and the store electrode. If the capacitance between the floating gate and the paddle is given by $C_{2M}$ and the remaining part of the steering capacitance is comprised of non-metallurgical channel capacitance, given by $c_{2C}$, the equations for the programmed and erased states floating gate voltages are given by

$$(V_{FG})_P = \frac{C_{21} - C_{32}}{C_{TOT}} \cdot \frac{V_{P3} - V_{P1}}{2} \cdot \frac{C_{2M} + C_{2C}}{C_{TOT}} \cdot \frac{V_{P3} + V_{P1}}{2} - \frac{C_{2M} + {}^1/C_{2C}}{C_{TOT}} V_{BIT} \tag{4}$$

and

$$(V_{FG})_E = \frac{C_{21}\text{-}C_{32}}{C_{TOT}} \cdot \frac{V_{P3}\text{-}V_{P1}}{2} \cdot \frac{C_{2M}\text{+}C_{2C}}{C_{TOT}} \cdot \frac{V_{P3}\text{+}V_{P1}}{2} \tag{5}$$

where $C_{TOT} = C_{21} + C_{32} + C_{2M} + C_{2C}$, and where $V_{BIT}$ is the bitline voltage.

Equations (4) and (5) were derived assuming that only those capacitances appearing are significant. $C_{2M}$ is also assumed to be much larger than $C_{2C}$, and that for the programmed state, $C_{2C}$ is only half of its full metallurgical capacitance value, and is its full capacitance value otherwise. This assumption has been found to reasonably describe observed behavior. The tunneling voltages across each of the tunneling elements are also assumed to be equal and of a value equal to half of the total voltage applied between poly 3 and poly 1 during write (just as in the paddleless case).

Since the size of the memory window is just the erased state potential minus the programmed state potential, subtracting Equation (4) from Equation (5) gives the size S of the memory window.

$$S = \frac{C_{2M} + (1/2)\, C_{2C}}{C_{TOT}} \; V_{BIT} \tag{6}$$

where the expression $(C_{2M} + \frac{1}{2}C_{2C})/C_{TOT}$ is known as the "Capacitance Coupling Efficiency."

Equation (6) shows that the size of the memory window is directly proportional to the capacitance coupling efficiency.

Thus, in order to maximize the size of the memory window of a memory cell, it is desirable to make the capacitance coupling efficiency as close to 100% as possible. That is, $C_{2M}$ and $C_{2C}$ should be much larger than $C_{32}$ and $C_{21}$.

Thus, one way to increase the size of the memory window is to decrease the values of capacitances $C_{32}$ and $C_{21}$. This can be achieved by increasing the thickness of the dielectric layers in all areas except in the regions of the first and second polysilicon layers where enhanced field emission electron tunneling is desired. Since the tunneling element capacitances $C_{32}$ and $C_{21}$ are sensitive to the thickness of the dielectric between the first and second polysilicon layers, the program/erase window will be increased if the thickness of the dielectric layers overlaying programming electrode 110 and floating gate 120 are increased.

A thicker dielectric layer also reduces the alignment sensitivity between the polysilicon layers. A thicker oxide layer means a reduced per unit area capacitance which results in a floating gate cell operating window which is less sensitive to misalignment.

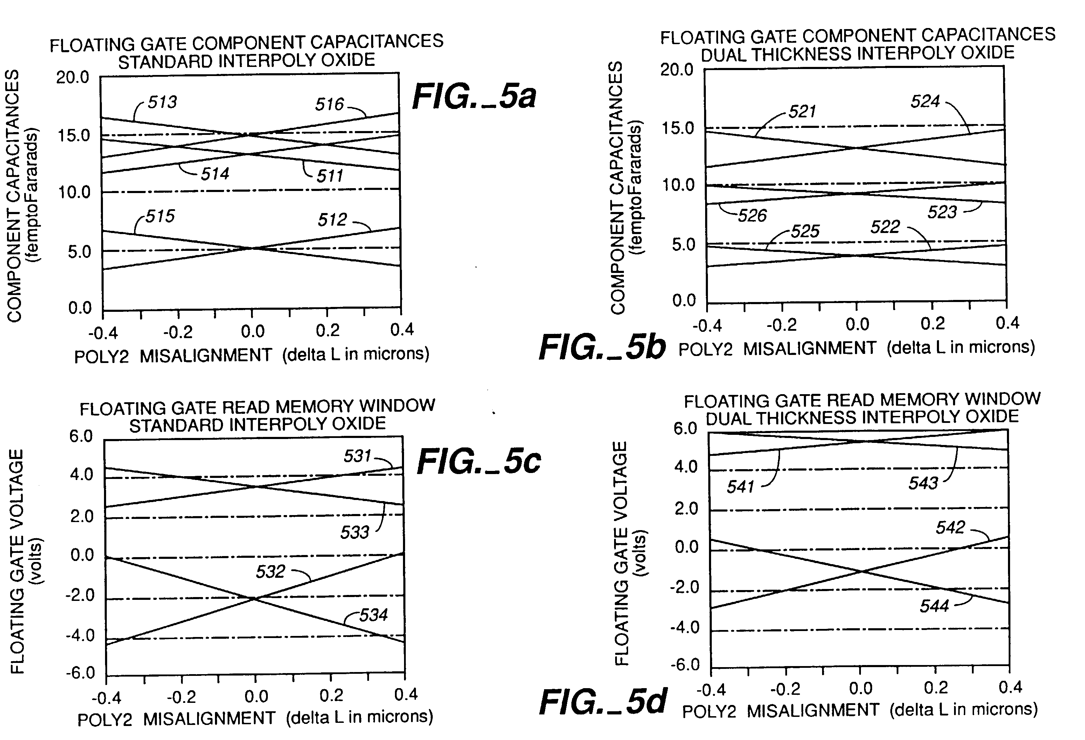

In arrays of memory cells, the cells are typically mirrored around electrical contact lines. Misalignment of polysilicon layers may occur during fabrication of the cells. Aligned mirrored memory cells according to the present invention and misaligned mirrored memory cells are shown in Figures 3(a) and 3(b), respectively.

As shown in Figure 3(b), the second polysilicon layer is misaligned by an amount given by $\Delta L$. This change of relative dimension results in an increase or decrease of the corresponding interpoly capacitance. There are various components of interpoly capacitance in semiconductor devices. Of interest here is the so-called variable capacitance arising from the planar interpoly region. This capacitance is strongly dependent on misalignment. The capacitance of the planar region (flat plate capacitance) is given by:

$$C = \frac{e_{ox} WL}{t_{ox}} \tag{7}$$

where W = the width of the polysilicon overlap region
L = the length of the overlap region
$t_{ox}$ = the thickness of the interpoly oxide
$e_{ox}$ = the dielectric constant of the oxide

Utilization of a thicker dielectric oxide for a significant portion of the planar region between the polysilicon layers thus decreases the total interpoly capacitance by reducing the flat plate capacitance. It likewise reduces the sensitivity of the capacitance to misalignment (dC/dL).

Under one case of misalignment conditions of the second polysilicon layer to the first and the third layer to the second, the capacitance of one tunneling element will grow while the other shrinks. This results in a shift of the center of the operating window which is given approximately by:

$$\Delta V_{WC} \approx \frac{\Delta C_{21}\text{-}\Delta C_{32}}{C_{TOT}} \; V_{TUN} \tag{8}$$

$$\text{where } \Delta C_{21} = \frac{e_{ox} W \Delta L}{t_{ox}}$$

$$\text{and } \Delta C_{32} = \frac{e_{ox} W \Delta L}{t_{ox}}$$

and where $V_{TUN}$ is the tunneling voltage across the tunnel elements and $C_{21}$ and $C_{32}$ are the change in respective capacitances due to misalignment.

The shift in the operating window center occurs for the following reason. During a write operation the first polysilicon layer and the third polysilicon layer capacitively pull in opposite directions (e.g., - 3 volts and + 25 volts) while during read, they capacitively pull in the same direction (e.g., both go to + 5 volts). Consequently, any capacitance imbalance due to misalignment will result in a floating gate memory window shift and this shift does not get compensated by the read operation bias conditions. Since in an array of memory cells the cells are mirrored around the electrical contact lines, this means that every other row of cells will have window shifts in one direction, while the other rows of cells will window shift in the opposite direction. Reference cells which track misalignment may ameliorate the situation, but there is a limit to the reference cell approach which occurs when the window is shifted so far negatively that an erased state floating gate voltage is too low to provide the necessary sensing current, or when the window shift is so positive that program cell conduction is excessive.

The dual thickness thick insulating layer of the present invention thus achieves distinct advantages over the prior art. For satisfactory levels of electron transmission to occur, some means must exist for enhancing the Fowler-Nordheim emission from the pertinent surface of the emitting conducting layer. The present invention preferably utilizes such a means comprising the formation of a microtextured surface on the emitting conducting layer. Other means for enhancing field emission by the pertinent conducting layer will be clear to those skilled in the semiconductor arts and thus are within the scope of the present invention. An example of such a means is enhanced emission from regions of the conducting layer with localized curvature, such as at corners or indentations on the surface thereof.

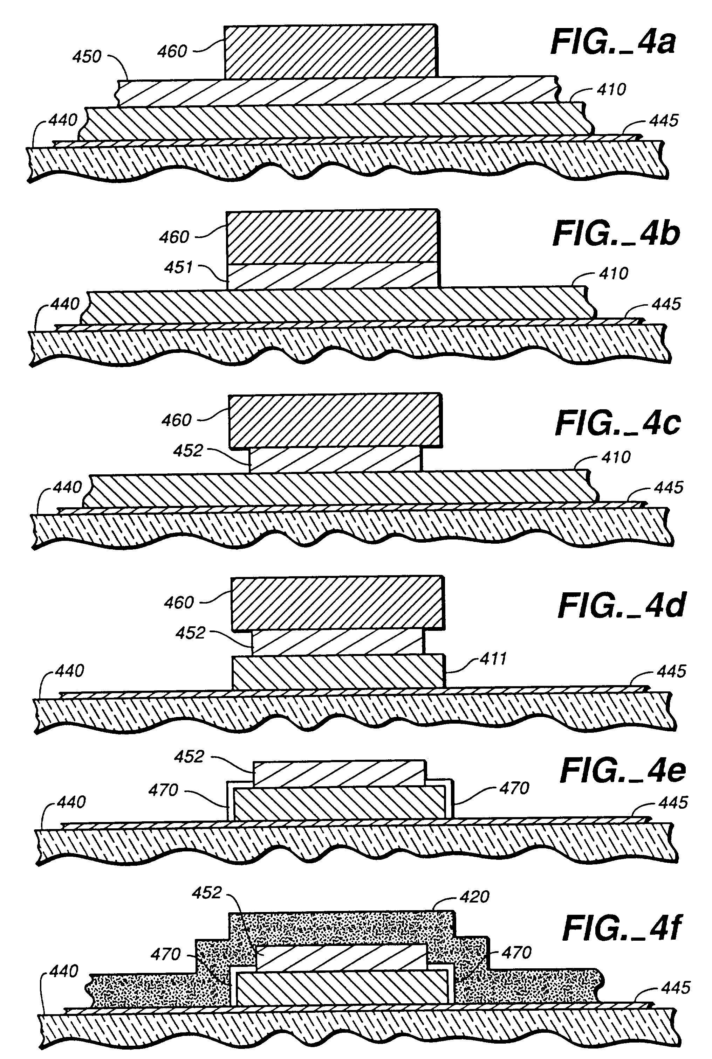

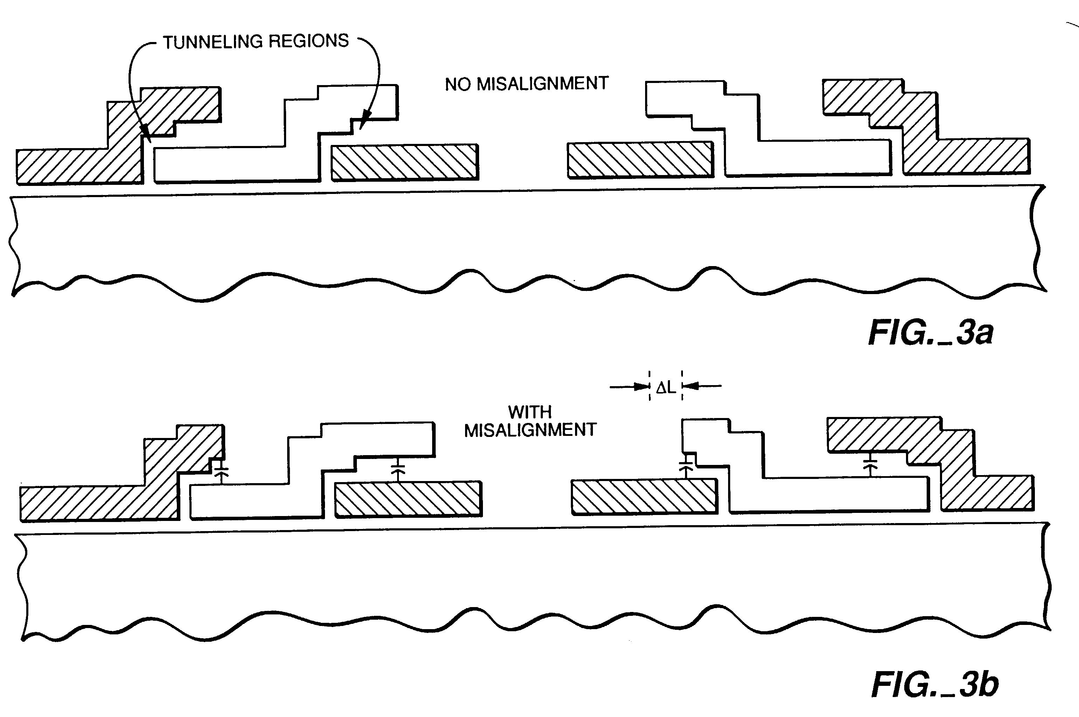

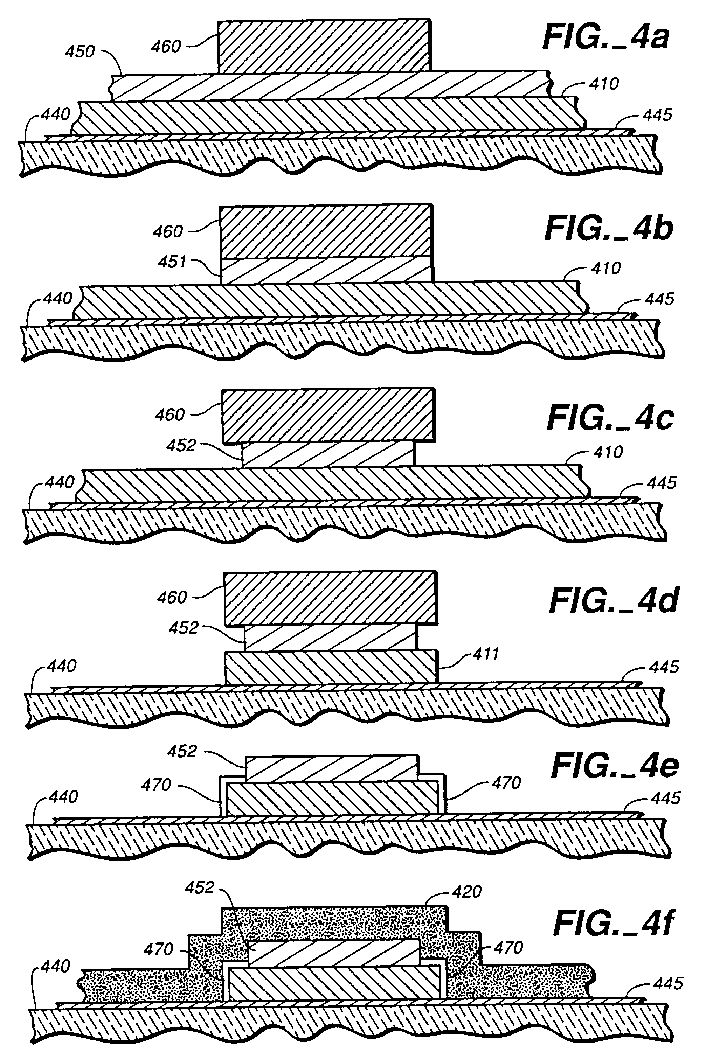

A process to form a dual thickness dielectric layer according to the present invention is illustrated using cross-sectional views in Figures 4(a) to 4(f).

Figure 4(a) shows a substrate 440 which has already undergone various conventional processing steps. Grown on top of substrate 440 is a gate oxide layer 445 of a predetermined thickness to provide the appropriate capacitance between substrate 440 and a first polysilicon layer 410 which is deposited on top of gate oxide layer 445. A thick interpoly oxide layer 450 is formed on first polysilicon layer 410. Conventional oxide layers are approximately 550 Angstroms thick. In the preferred embodiment of the present invention, thick oxide layer 450 is at least double the thickness of a conventional oxide layer. For example, the thickness of thick oxide layer 450 can be greater than or equal to 1400 Angstroms. Thick oxide layer 450 may be formed, for example by low-pressure chemical vapor deposition or thermal oxidation. In forming thick oxide layer 450 on first polysilicon layer 410, the surface of the latter becomes microtextured, producing locally curved surfaces which enhance the electric field locally such that enhanced field emission tunneling is enabled to occur from the surface of the polysilicon layer 410.. A photoresist layer 460 is applied to thick oxide layer 450 in a conventional manner. Figure 4(b) shows a conventional anisotropic oxide etch step wherein thick oxide layer 450 (of Figure 4(a)) is etched according to a pattern established by photoresist layer 460 to form thick oxide layer 451.

Figure 4(c) shows the step of under-cutting thick oxide layer 451 (of Figure 4(b)) with respect to the overlying photoresist layer 460. This under-cutting is performed using conventional wet or plasma oxide etch techniques to form an under-cut thick oxide layer 452. The undercut can be uniformly done and is easily reproducible. The amount of under-cut is several times the thickness of the thick oxide layer according to the present invention. For example, the under-cut can be 0.2 to 0.3 microns. Figure 4(d) shows the next step of the anisotropic etch of first polysilicon layer 410 (of Figures 4(a) to 4(c)) to form first polysilicon layer 411 which is sized to conform to the desired specifications of the memory cell being fabricated. Note that the boundaries of the photoresist layer 460 define the boundaries of etched polysilicon layer 411. Photoresist 460 (of Figures 4(a) to 4(d)) is then removed. Figure 4(e) shows the process for forming tunneling oxide layers 470 by forming an insulating oxide layer over the exposed regions of first polysilicon layer 411 and first gate oxide layer 445. This results particularly in an insulating oxide layer on the shoulders of first polysilicon layer 411 contiguous with under-cut thick oxide layer 452. Note that thick oxide portion 452 can be masked during formation of oxide layer 470 or its thickness increased when layer 470 is formed, in a manner conventional in the art. Oxide layers 470 are formed so as to have a predetermined thickness that is much less than the thickness of oxide layer 450 (e.g., approximately 450 Angstroms versus 1400 Angstroms). This approach allows the precise control of the critical dimensions of the tunneling regions according to the present invention. A second polysilicon layer 420 is deposited over under-cut thick oxide layer 452, tunneling regions 470, and gate oxide layer 445 in a conventional manner as shown in Figure 4(f).

Experimentation has shown that the increased thickness of thick oxide layer 452 reduces nominal interpoly capacitance $C_{32}$ by approximately 40% and nominal interpoly capacitance $C_{21}$ by approximately 25%. This results in two significant improvements.

First, the nominal floating gate memory window margin (erased state voltage minus program state voltage) is improved by approximately 1 volt, which is approximately an 18% improvement in memory window size. Second, memory cells fabricated according to the present invention have reduced sensitivity to misalignment by approximately a factor of 2. For example, if the interpoly oxide is four times thicker, the window center shift is only one-fourth that produced by a thinner oxide for the same misalignment. This is a result of the reduced per unit area capacitance which produces a memory window center which is less sensitive to misalignment.

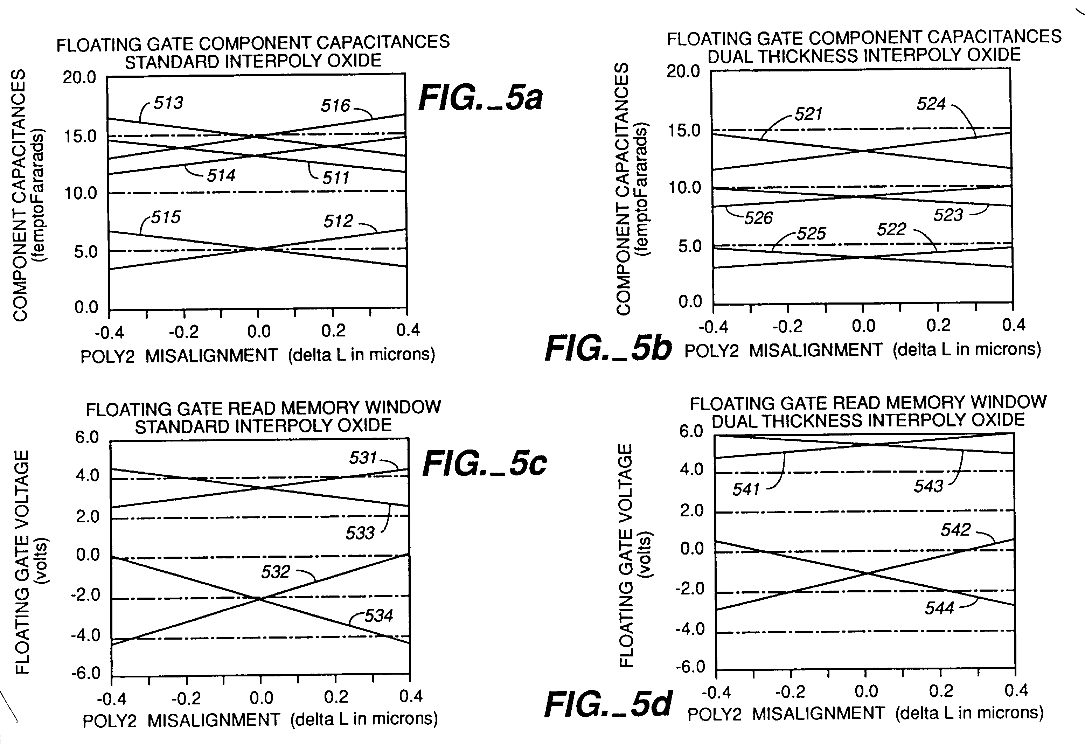

An example of the improvement on the floating gate memory window is illustrated in Figures 5(a) to 5(d). The + and - signs denote the cell and its mirror image. Figure 5(a) shows the values of the various capacitances as a function of poly 2 misalignment ( L) for the case of a single thickness oxide layer. Capacitor C2S- is shown at 511, capacitor C21- is shown at 512, capacitor C32- is shown at 513, capacitor C2S+ is shown at 514, capacitor C21+ is shown at 515 and capacitor C332+ is shown at 516 in Figure 5(a). Figure 5(b) shows the capacitances according to the present invention. In Figure 5(b), capacitor C2S- is shown at 521, capacitor C21- is shown at 522, capacitor C32- is shown at 523, capacitor C2S+ is shown at 524, capacitor C21+ is shown at 525 and capacitor C32+ is shown at 526. As can be seen, the capacitances C21, C32 according to the present invention are almost all smaller for the entire range of misalignment shown. These decreased capacitances produce a larger floating gate memory window as a function of misalignment as shown in Figures 5(c) and 5(d). Figures 5(c) and 5(d) show the floating gate voltages for the erased and programmed states of the mirrored cells for the single thickness oxide case and the dual thickness oxide of the present invention. In Figure 5(c) ERASE- is shown at 531, PROGRAM- is shown at 532, ERASE+ is shown at 533 and PROGRAM+ is shown at 534. In Figure 5(d), ERASE- is shown at 541, PROGRAM- is shown at 542, ERASE+ is shown at 543 and PROGRAM+ is shown at 544. Recall that the memory window is just the erased state voltage minus the programmed state voltage. It can be seen that the present invention increases the memory window size for all values of misalignment.

By reducing the interpoly capacitances with respect to the steering capacitance, the alignment sensitivity of the memory window is reduced. This allows for the use of lower write voltages to achieve comparable memory window size for a given range of misalignment or to allow more relaxed alignment tolerances for a given write voltage.

An improved nonvolatile memory cell and a process for manufacturing same has been described. It will be appreciated by those skilled in the art that the present invention is applicable to similar devices based upon electron tunneling and controlled capacitances, and that the present invention is to be limited solely by the scope of the following claims.

## Claims

1. A semiconductor integrated circuit device having first and second conducting layers (110, 120) separated by a dielectic layer (101), said first conducting layer (110) having a surface including at least one region of localized curvature which enhances the electric field locally such that the application of a potential difference between said first and second conducting layers will cause enhanced field emission tunneling of electrons to occur from said first conducting layer (110) through said dielectric layer (101) to said second conducting layer (120); <u>characterised in that</u> said dielectric layer (101) includes first (470) and second (452) portions formed on said surface of said first conducting layer, the first portion (470) adjacent said region of localized curvature and having a first thickness and the second portion (452) having a second, relatively greater, thickness, such that said enhanced field emission tunneling is caused to occur primarily through said first portion (470) of said dielectric layer from said first conducting layer (110) to said second conducting layer (120).

2. A device according to claim 1 wherein said localized curvature comprises a microtextured surface formed on or adjacent to the top surface of said first conducting layer (110).

3. A device according to claim 1 wherein said first and said second conducting layers (110,120) are formed from polysilicon.

4. A device according to claim 1 wherein said second thickness (452) is at least 100 nm (1,000 angstroms) and said first thickness (470) is less than 60 nm (600 angstroms).

5. A device according to claim 1, wherein said first conducting layer (110) includes a corner portion surrounded by said dielectric layer and said second conducting layer (120); said surface of said first conducting layer has at least one region of localized curvature in the vicinity of said corner which enhances the electric field locally; and said first portion (470) of said dielectric layer (101) is positioned adjacent said corner region of localized curvature.

6. A device according to any preceding claim in which the semiconductor integrated device is a floating gate nonvolatile memory cell and the first conducting layer (110,411) is a polysilicon layer formed on top of an oxide layer (445).

7. A memory cell according to claim 6 including a further dielectric layer (102) disposed on a top surface of said second polysilicon layer (120); a third polysilicon layer (130) disposed partially on the top surface of said oxide layer (445) and partially overlying said further dielectric layer (102) so as to overlie a portion of said second polysilicon layer (120); wherein said further dielectric layer (102) includes a first portion (470) having a first thickness and a second portion (452) having a second greater thickness, such that the application of a potential difference between said second polysilicon layer (120) and said third polysilicon layer (130) will cause enhanced field emission tunneling to occur from said second polysilicon layer to said third polysilicon layer (130) primarily through said first portion (470) of said further dielectric layer (102).

8. A memory cell according to claim 7 wherein said first polysilicon layer (110) comprises a program electrode, said second polysilicon layer (120) comprises a floating gate electrode at least a portion of which overlies the textured surface of said program electrode, and at least a portion of which has a textured upper surface, said floating gate being surrounded by said dielectric and further dielectric layers (101,102), and said third polysilicon layer (130) comprises an erase electrode at least a portion of which overlies the textured surface of said floating gate, and wherein the thickness of said dielectric material surrounding said electrodes exceeds 45 nm (450A) in those areas (470) where tunneling occurs and wherein said dielectric material is at least 100 nm (1000 angstroms) thick in at least a portion of the remaining areas (452).

9. A memory cell according to claim 8 wherein said program electrode (110) has a corner generally surrounded by said floating gate electrode (120), and wherein said tunneling will occur primarily in the region of said corner.

10. A method for forming a semiconductor integrated circuit device, comprising the steps of:

(a) forming a first conducting layer (410,411) on an underlying first insulating layer (445);

(b) forming regions of enhanced field emission on said first conducting layer (410,411);

(c) forming a second insulating layer (452) of a predetermined thickness on the exposed surfaces of said first conducting layer (410,411);

(d) forming a masking layer (460) having a predetermined pattern on a top surface of said second insulating layer (452) thereby forming a pattern in said second insulating layer (452) so as to expose predetermined regions of said first conducting layer (410,411);

(e) under-cutting said second insulating layer (452) by an etching process a predetermined amount interior to the edge boundaries of said masking layer;

(f) etching said first conducting layer (411) according to said predetermined pattern defined by said masking layer (460);

(g) forming a third insulating layer (470) on all exposed surfaces, such that a resultant insulating layer on top of said first conducting layer has first and second regions (470,452) of different predetermined thicknesses the thickness of the second portion being greater than that of the first portion; and

(h) forming a second conducting layer (420) over said resultant insulating layer (470,452).

11. A method according to claim 10 wherein the step (c) of forming a second insulating layer (470,452) includes modifying the exposed surfaces of said first conducting layer (411) so as to further enhance field emission tunneling off of said first conducting layer (411).

12. A method according to claim 10 wherein said first and second conducting layers (411,420) are polysilicon.

13. A method according to claim 10 wherein said predetermined thickness of said second region (452) of said resultant layer is at least 100 nm (1000 angstroms) and said predetermined thickness of said first region (470) of said resultant layer is less than 60 nm (600 angstroms).

14. A method according to claim 10 wherein said etching process in step (e) is a wet oxide etch technique.

15. A method according to claim 10 wherein said etching process in step (e) is an isotropic plasma oxide etch technique.

16. A method according to claim 10 wherein the extent of said under-cut in step (e) is 0.2 microns to 0.3 microns laterally from the edge of said predetermined pattern of said masking layer (460).

17. A method according to claim 10 wherein said semiconductor integrated circuit device is a floating gate nonvolatile memory cell.

18. A method according to claim 10 wherein said third insulating layer (102) is of a thickness that is substantially less than the sum of said predetermined thickness of said second insulating layer (101) and said third insulating layer (102).

19. A method according to claim 10 wherein thermal oxidation is utilized in forming said second insulating layer (452) of step (c).

20. A method according to claim 10 wherein low pressure chemical vapor deposition is utilized in forming said second insulating layer (452) of step (c).

21. A method according to claim 10 wherein thermal oxidation and low pressure chemical vapor deposition are utilized in forming said second insulating layer (452) of step (c).

22. A method according to claim 10 wherein said conducting layers (411,420) are formed from polysilicon and wherein said step of forming regions of enhanced field emission is performed by the formation of said second insulating layer (470,452) on said first conducting layer (411).

23. A method according to any preceding claim in which the device comprises a floating gate semiconductor memory device, the first insulating layer (445) is a gate oxide layer of predetermined thickness formed on top of a semiconductor substrate (440), the first conducting layer (411) is formed of polysilicon and the regions of enhanced field emission comprise a microtextured surface, the second insulating layer (452) is an interpoly oxide layer formed relatively thickly on the polysilicon surface, the etching of the interpoly oxide layer (452) and the polysilicon layer (411) in steps (e) and (f) exposes corner portions of the polysilicon layer over which the third insulating layer is deposited, the third insulating layer being formed relatively thinly as a tunneling oxide and the second conducting layer also comprises polysilicon.

24. A method according to claim 23 wherein the etching of the interpoly oxide layer and said first polysilicon layer comprises (i) forming a photoresist layer of a desired pattern on said first polysilicon layer; (ii) anisotropically etching said first polysilicon layer; and (iii) isotropically etching said interpoly oxide layer.

25. A method according to claim 24, further comprising removing said photoresist layer before the relatively thin tunneling oxide layer has been deposited.

**Patentansprüche**

1. Eine integrierte Halbleiter-Schaltkreisvorrichtung mit einer ersten und einer zweiten leitenden Schicht (110, 120), die durch eine Dielektrikumschicht (101) getrennt sind, wobei die erste leitende Schicht (110) eine Oberfläche hat, die wenigstens einen Bereich lokalisierter Krümmung aufweist, die das elektrische Feld örtlich verstärkt, so daß das Anlegen einer Potentialdifferenz zwischen der ersten und der zweiten leitenden Schicht ein verstärktes Feldemissions-Tunneln von Elektronen von der ersten leitenden Schicht (110) durch die Dielektrikumschicht (101) zur zweiten leitenden Schicht (120) bewirkt; dadurch gekennzeichnet, daß die Dielektrikumschicht (101) einen ersten (470) und einen zweiten (452) Teil beinhaltet, die auf der Oberfläche der ersten leitenden Schicht ausgebildet sind, wobei der erste Teil (470), der anliegend an den Bereich der örtlichen Krümmung eine erste Dicke aufweist, und der zweite Teil (452) eine zweite, relativ größere Dicke hat, so daß das verstärkte Feldemissions-Tunneln in erster Linie durch den ersten Teil (470) der Dielektrikumschicht von der ersten leitenden Schicht (110) zur zweiten leitenden Schicht (120) erfolgt.

2. Eine Vorrichtung gemäß Anspruch 1, in dem die lokalisierte Krümmung eine Mikrogefügefläche aufweist, die auf oder an der oberen Oberfläche der ersten leitenden Schicht (110) ausgebildet ist.

3. Eine Vorrichtung gemäß Anspruch 1, in dem die erste und die zweite leitende Schicht (110, 120) aus Polysilicium gebildet sind.

4.  Eine Vorrichtung gemäß Anspruch 1, in dem die zweite Dicke (452) wenigstens 100 nm (1 000 Å) und die erste Dicke (470) weniger als 60 nm (600 Å) beträgt.

5.  Eine Vorrichtung gemäß Anspruch 1, in dem die erste leitende Schicht (110) einen Eckenteil beinhaltet, der von der Dielektrikumschicht und der zweiten leitenden Schicht (120) umgeben ist; wobei die Oberfläche der ersten leitenden Schicht wenigstens einen Bereich mit einer lokalisierten Krümmung in der Nähe dieser Ecke aufweist, die das elektrische Feld örtlich verstärkt; und der erste Teil (470) der Dielektrikumschicht (101) anliegend an den Eckenbereich örtlicher Krümmung gelegen ist.

6.  Eine Vorrichtung gemäß einem beliebigen der vorstehenden Ansprüche, in dem die integrierte Halbleitervorrichtung eine nichtflüchtige Speicherzelle mit schwebendem Gate ist und die erste leitende Schicht (110, 411) eine Polysiliciumschicht ist, die oben auf einer Oxidschicht (445) ausgebildet ist.

7.  Eine Speicherzelle gemäß Anspruch 6, beinhaltend eine weitere Dielektrikumschicht (102), die auf einer oberen Oberfläche der zweiten Polysiliciumschicht (120) aufgebracht ist; eine dritte Polysiliciumschicht (130) teilweise auf der oberen Oberfläche der Oxidschicht (445) aufgebracht ist und teilweise die weitere Dielektrikumschicht (102) überlagert, so daß sie einen Teil der zweiten Polysiliciumschicht (120) überlagert; wobei die weitere Dielektrikumschicht (102) einen ersten Teil (470) mit einer ersten Dicke und einen zweiten Teil (452)mit einer zweiten, größeren, Dicke beinhaltet, so daß das Anlegen einer Potentialdifferenz zwischen der zweiten Polysiliciumschicht (120) und der dritten Polysiliciumschicht (130) ein verstärktes Feldemissions-Tunneln von der zweiten Polysiliciumschicht zur dritten Polysiliciumschicht (130) in erster Linie durch den ersten Teil (470) der weiteren Dielektrikumschicht (102) bewirkt.

8.  Eine Speicherzelle gemäß Anspruch 7, in der die erste Polysiliciumschicht (110) eine Programmelektrode beinhaltet, die zweite Polysiliciumschicht (120) eine Schwebendes-Gate-Elektrode beinhaltet, die mindestens teilweise die Texturoberfläche der Programmelektrode überlagert, und mindestens ein Teil derselben eine obere Texturoberfläche aufweist, wobei das schwebende Gate von der Dielektrikumschicht und noch weiteren Dielektrikumschichten (101, 102) umgeben ist, und die dritte Polysiliciumschicht (130) eine Löschelektrode beinhaltet, von der wenigstens ein Teil die Texturoberfläche des schwebenden Gate überlagert und wobei die Dicke des Dielektrikummaterials, das die Elektroden umgibt, mehr als 45 nm (450 Å) in den Bereichen (470) ausmacht, in denen das Tunneln auftritt, und wobei das Dielektrikummaterial in wenigstens einem Teil der restlichen Bereiche (452) mindestens 100 nm (1000 Å) dick ist.

9.  Eine Speicherzelle gemäß Anspruch 8, in der die Programmelektrode (110) eine Ecke aufweist, die im allgemeinen von der Schwebendes-Gate-Elektrode (120) umgeben ist und in der das Tunneln in erster Linie im Bereich dieser Ecke stattfindet.

10. Ein Verfahren zum Ausbilden einer integrierten Halbleiter-Schaltkreisvorrichtung, das die folgenden Schritte umfaßt:

    (a) Ausbilden einer ersten leitenden Schicht (410, 411) auf einer darunterliegenden ersten Isolierschicht (445);

    (b) Ausbilden von Bereichen erhöhter Feldemission auf dieser ersten leitenden Schicht (410, 411);

    (c) Ausbilden einer zweiten Isolierschicht (452) einer vorgegebene Dicke auf der freiliegenden Oberfläche der ersten leitenden Schicht (410, 411);

    (d) Ausbilden einer Maskierungsschicht (460) mit einem vorgegebenen Muster auf einer oberen Fläche der zweiten Isolierschicht (452), dabei Ausbilden eines Musters in der zweiten Isolierschicht (452), so daß vorbestimmte Bereiche der ersten leitenden Schicht (410, 411) freigelegt werden;

    (e) Hinterschneiden der zweiten Isolierschicht (452) durch einen Ätzprozeß um einen vorgegebenen Betrag innerhalb der Kantengrenzen der Maskierungsschicht;

    (f) Ätzen der ersten leitenden Schicht (411) gemäß dem vorgegebenen Muster, das durch die Maskierungsschicht (460) definiert ist;

(g) Ausbilden einer dritten Isolierschicht (470) auf allen freigelegten Oberflächen, so daß eine resultierende Isolierschicht oben auf der ersten leitenden Schicht einen ersten und einen zweiten Bereich (470, 452) unterschiedlicher vorgegebener Dicken aufweist, wobei die Dicke des zweiten Teils größer als die Dicke des ersten Teils ist; und

(h) Ausbilden einer zweiten leitenden Schicht (420) auf der sich ergebenden Isolierschicht (470, 452).

11. Ein Verfahren gemäß Anspruch 10, in dem der Schritt (c) des Ausbildens einer zweiten Isolierschicht (470, 452) das Verändern der freigelegten Oberflächen der ersten leitenden Schicht (411) beinhaltet, um das Feldemissions-Tunneln von der ersten Leiterfläche (411) noch weiter zu verstärken.

12. Ein Verfahren gemäß Anspruch 10, in dem die erste und die zweite leitende Schicht (411, 420) aus Polysilicium sind.

13. Ein Verfahren gemäß Anspruch 10, in dem die vorgegebene Dicke des zweiten Bereichs (452) der sich ergebenden Schicht mindestens 100 nm (1000 Å) beträgt, und die vorgegebene Dicke des ersten Bereichs (470) der sich ergebenden Schicht weniger als 60 nm (600 Å) beträgt.

14. Ein Verfahren gemäß Anspruch 10, in dem der Ätzprozeß in Schritt (e) eine Naßoxid-Ätztechnik ist.

15. Ein Verfahren gemäß Anspruch 10, in dem der Ätzprozeß in Schritt (e) eine isotrope Plasmaoxid-Ätztechnik ist.

16. Ein Verfahren gemäß Anspruch 10, in dem das Ausmaß des Hinterschnitts in Schritt (e) 0,2 $\mu$m bis 0,3 $\mu$m seitlich von der Kante des vorgegebenen Musters der Maskierungsschicht (460) beträgt.

17. Ein Verfahren gemäß Anspruch 10, in dem die integrierte Halbleitervorrichtung eine nichtflüchtige Speicherzelle mit schwebendem Gate ist.

18. Ein Verfahren gemäß Anspruch 10, in dem die dritte Isolierschicht (102) eine Dicke aufweist, die wesentlich geringer ist als die Summe der Dicke der zweiten Isolierschicht (101) und der dritten Isolierschicht (102).

19. Ein Verfahren gemäß Anspruch 10, in dem thermische Oxidation benutzt wird zum Ausbilden der zweiten Isolierschicht (425) des Schritts (c).

20. Ein Verfahren gemäß Anspruch 10, in dem chemische Niederdruck-Dampfabscheidung benutzt wird zum Ausbilden der zweiten Isolierschicht (452) des Schritts (c).

21. Ein Verfahren gemäß Anspruch 10, in dem thermische Oxidation und chemische Niederdruck-Dampfabscheidung benutzt werden zum Ausbilden der zweiten Isolierschicht (452) des Schritts (c).

22. Ein Verfahren gemäß Anspruch 10, in dem die leitenden Schichten (411, 420) aus Polysilicium gebildet werden und der Schritt zum Ausbilden von Bereichen der verstärkten Feldemission durch das Ausbilden der zweiten Isolierschicht (470, 452) auf der ersten leitenden Schicht (411) durchgeführt wird.

23. Ein Verfahren gemäß einem beliebigen der vorstehenden Ansprüche, in dem die Vorrichtung eine Halbleiterspeichervorrichtung mit schwebendem Gate beinhaltet, wobei die erste Isolierschicht (445) eine Gate-Oxidschicht vorbestimmter Dicke ist, die oben auf einem Halbleitersubstrat (440) ausgebildet ist, die erste leitende Schicht (411) aus Polysilicium gebildet ist, und die Bereiche der erhöhten Feldemission eine Mikrogefügeoberfläche beinhalten, die zweite Isolierschicht (452) eine Interpolyoxidschicht ist, die verhältnismäßig dick auf der Polysiliciumoberfläche ausgebildet ist, das Ätzen der Interpolyoxidschicht (452) und der Polysiliciumschicht (411) in den Schritten (e) und (f) Eckenteile der Polysiliciumschicht freilegt, über die die dritte Isolierschicht gelegt wird, wobei die dritte Isolierschicht verhältnismäßig dünn als ein Tunneloxid ausgebildet wird, und auch die zweite leitende Schicht Polysilicium beinhaltet.

24. Ein Verfahren gemäß Anspruch 23, in dem das Ätzen der Interpolyoxidschicht und der ersten Polysiliciumschicht (i) das Ausbilden einer Photoresistschicht mit einem gewünschten Muster auf der ersten Polysiliciumschicht; (ii) anisotropes Ätzen der ersten Polysiliciumschicht; und (iii) isotropes Ätzen der Interpolyoxidschicht beinhaltet.

25. Ein Verfahren gemäß Anspruch 24, das ferner beinhaltet das Abziehen der Photoresistschicht bevor die verhältnismäßig dünne Tunneloxidschicht aufgebracht worden ist.

## Revendications

1. Dispositif à circuit intégré à semi-conducteur comportant des première et seconde couches conductrices (110, 120) séparées par une couche diélectrique (101), ladite première couche conductrice (110) ayant une surface incluant au moins une région de courbure localisée qui renforce localement le champ électrique de sorte que l'application d'une différence de potentiel entre lesdites première et seconde couches conductrices provoquera l'apparition d'un effet tunnel à émission de champ renforcée d'électrons, à partir de ladite première couche conductrice (110), à travers ladite couche diélectrique (101), vers ladite seconde couche conductrice (120) ; caractérisé en ce que ladite couche diélectrique (101) comprend des première (470) et seconde (452) parties formées sur ladite surface de ladite première couche conductrice, la première partie (470) étant adjacente à ladite région de courbure localisée et ayant une première épaisseur et la seconde partie (452) ayant une seconde épaisseur, relativement plus grande, de façon telle que ledit effet de tunnel à émission de champ renforcé est amené à se produire principalement à travers ladite première partie (470) de ladite couche diélectrique, à partir de ladite première couche conductrice (110) vers ladite seconde couche conductrice (120).

2. Dispositif selon la revendication 1, dans lequel ladite courbure localisée comprend une surface microtexturée formée sur, ou adjacente à, la surface supérieure de ladite première couche conductrice (110).

3. Dispositif selon la revendication 1, dans lequel lesdites première et seconde couches conductrices (110, 120) sont faites de silicium polycristallin.

4. Dispositif selon la revendication 1, dans lequel ladite seconde épaisseur (452) est d'au moins 100 nm (1.000 Angströms) et dans lequel ladite première épaisseur (470) est d'au moins 60 nm (600 Angströms).

5. Dispositif selon la revendication 1, dans lequel une partie coin de ladite première couche conductrice (110) est entourée par ladite couche diélectrique et ladite seconde couche conductrice (120) ; dans lequel ladite surface de ladite première couche conductrice a au moins une région de courbure localisée au voisinage dudit coin ce qui renforce localement le champ électrique ; et dans lequel ladite première partie (470) de ladite couche diélectrique (101) est située adjacente à ladite région de coin à courbure localisée.

6. Dispositif selon l'une quelconque des revendications précédentes, dans lequel le dispositif intégré à semi-conducteur est une cellule de mémoire non volatile à grille flottante ; et dans lequel la première couche conductrice (110, 411) est une couche de silicium polycristallin formée sur le dessus d'une couche d'oxyde (445).

7. Cellule de mémoire selon la revendication 6, comprenant une couche diélectrique supplémentaire (102) disposée sur la surface supérieure de ladite seconde couche de silicium polycristallin (120) ; une troisième couche de silicium polycristallin (130) disposée partiellement sur la surface supérieure de ladite couche d'oxyde (445) et recouvrant partiellement ladite couche diélectrique supplémentaire (102) de façon à recouvrir une partie de ladite deuxième couche de silicium polycristallin (120) ; dans lequel ladite couche diélectrique supplémentaire (102) comprend une première partie (470) ayant une première épaisseur et une seconde partie (452) ayant une seconde épaisseur plus grande, de sorte que l'application d'une différence de potentiel entre ladite deuxième couche de silicium polycristallin (120) et ladite troisième couche de silicium polycristallin (130) provoquera l'apparition d'un effet tunnel à émission de champ renforcée à partir de ladite deuxième couche de silicium polycristallin vers ladite troisième couche de silicium polycristallin (130), principalement à travers ladite première partie (470) de ladite couche diélectrique supplémentaire (102).

8. Cellule de mémoire selon la revendication 7, dans laquelle ladite première couche de silicium polycristallin (110) comprend une électrode de programmation, ladite deuxième couche de silicium polycristallin (120) comprend une électrode à grille flottante dont au moins une partie recouvre la surface texturée de ladite électrode de programmation, et dont au moins une partie a une surface supérieure texturée, ladite grille flottante étant entourée par ledit diélectrique et lesdites couches diélectriques supplémentaires (101, 102), et dans laquelle ladite troisième couche de silicium polycristallin (130) comprend une électrode d'effacement dont au moins une partie recouvre la surface texturée de ladite grille flottante ; et dans laquelle l'épaisseur de ladite matière diélectrique entourant lesdites électrodes dépasse 45 nm (450 Å) dans les zones (470) où l'effet tunnel se produit et dans lesquelles ladite matière diélectrique est d'au moins 100 nm (1.000 Angströms) d'épaisseur dans au moins une partie des zones restantes (452).

9. Cellule de mémoire selon la revendication 8, dans laquelle un coin de ladite électrode de programmation (110) est globalement entouré par ladite électrode à grille flottante (120) ; et dans laquelle l'effet tunnel se produira principalement dans la région dudit coin.

10. Procédé de formation d'un dispositif à circuit intégré à semi-conducteur, comprenant les étapes :

(a) de formation d'une première couche conductrice (410, 411) sur une première couche isolante sous-jacente (445) ;
(b) de formation de régions d'émission de champ renforcée sur ladite première couche conductrice (410, 411) ;
(c) de formation d'une deuxième couche isolante (452) d'une épaisseur prédéterminée sur les surfaces mises à nu de ladite première conductrice (410, 411) ;
(d) de formation d'une couche de masquage (460) ayant un motif prédéterminé sur la surface supérieure de ladite seconde couche isolante (452), en formant ainsi un motif dans ladite seconde isolante (452) de manière à mettre à nu des régions prédéterminées de ladite première couche conductrice (410, 411) ;
(e) de creusement par en dessous ladite deuxième couche isolante (452) à l'aide d'un procédé d'attaque d'une quantité prédéterminée à l'intérieur des limites de bord de ladite couche de masquage ;
(f) d'attaque de ladite première couche conductrice (411) suivant ledit motif prédéterminé défini par ladite couche de masquage (460) ;
(g) de formation d'une troisième couche isolante (470) sur toutes les surfaces accessibles, de sorte qu'une couche isolante résultante sur le dessus de ladite première couche conductrice comporte des première et seconde régions (470, 452) d'épaisseurs prédéterminées différentes, l'épaisseur de la seconde région étant plus grande que celle de la première région ; et
(h) de formation d'une seconde couche conductrice (420) sur ladite couche isolante résultante (470, 452).

11. Procédé selon la revendication 10, dans lequel l'étape (c) de formation d'une seconde couche isolante (470, 452) comprend la modification des surfaces mises à nu de ladite première couche conductrice (411) de façon à renforcer davantage l'effet de tunnel à émission de champ renforcée à partir de ladite première couche conductrice (411).

12. Procédé selon la revendication 10, dans lequel lesdites première et seconde couches conductrices (411, 420) sont en silicium polycristallin.

13. Procédé selon la revendication 10, dans lequel ladite épaisseur prédéterminée de ladite seconde région (452) de ladite couche résultante est d'au moins 100 nm (1.000 Angströms) et ladite épaisseur prédéterminée de ladite première région (470) de ladite couche résultante est d'au moins 60 nm (600 Angströms).

14. Procédé selon la revendication 10, dans lequel ledit traitement d'attaque de l'étape (e) est une technique d'attaque de l'oxyde en milieu liquide.

15. Procédé selon la revendication 10, dans lequel ledit traitement d'attaque de l'étape (e) est une technique d'attaque isotrope de l'oxyde au plasma.

16. Procédé selon la revendication 10, dans lequel l'étendue dudit creusement par en dessous de ladite étape (e) est de 0,2 micron à 0,3 micron latéralement à partir du bord dudit motif prédéterminé de ladite couche de masquage (460).

17. Procédé selon la revendication 10, dans lequel ledit dispositif à circuit intégré à semi-conducteur est une cellule de mémoire non volatile à grille flottante.

18. Procédé selon la revendication 10, dans lequel ladite troisième couche isolante (102) est d'une épaisseur qui est sensiblement plus petite que la somme de ladite épaisseur prédéterminée de ladite deuxième couche isolante (101) et de ladite troisième couche isolante (102).

19. Procédé selon la revendication 10, dans lequel on utilise une oxydation thermique pour former ladite deuxième couche isolante (452) de l'étape (c).

20. Procédé selon la revendication 10, dans lequel on utilise un dépôt chimique en phase vapeur à basse pression pour former ladite deuxième couche isolante (452) de l'étape (c).

21. Procédé selon la revendication 10, dans lequel on utilise une oxydation thermique et un dépôt chimique en phase vapeur à basse pression pour former ladite deuxième couche isolante (452) de l'étape (c).

22. Procédé selon la revendication 10, dans lequel lesdites couches conductrices (411, 420) sont formées à partir de silicium polycristallin ; et dans lequel ladite étape de formation de régions à émission de champ renforcée s'effectue par la formation de ladite deuxième couche isolante (470, 452) sur ladite première couche conductrice (411).

23. Procédé selon l'une quelconque des revendications précédentes, dans lequel le dispositif comprend un dispositif de mémoire à semi-conducteur à grille flottante, la première couche isolante (445) est une couche d'oxyde de grille d'une épaisseur prédéterminée formée sur le dessus d'un substrat semi-conducteur (440), la première couche conductrice (411) est faite de silicium polycristallin et les régions à émission de champ renforcé comprennent une surface microtexturée, la deuxième couche isolante (452) est une couche d'oxyde entre couches de silicium polycristallin, formée relativement épaisse sur la surface de silicium polycristallin, l'attaque de la couche d'oxyde entre couches de silicium polycristallin (452) et de la couche de silicium polycristallin (411) aux étapes (e) et (f) met à nu les parties coins de la couche de silicium polycristallin sur laquelle est déposée la troisième couche isolante, la troisième couche isolante étant formée relativement mince en tant qu'oxyde pour effet tunnel, et la deuxième couche conductrice comprend également du silicium polycristallin.

24. Procédé selon la revendication 23, dans lequel l'attaque de la couche d'oxyde entre couches de silicium polycristallin et de ladite première couche de silicium polycristallin comprend (i) la formation d'une couche de photorésist d'un motif voulu sur ladite première couche de silicium polycristallin ; (ii) l'attaque de manière anisotrope de ladite première couche de silicium polycristallin et (iii) l'attaque de manière isotrope de ladite couche d'oxyde entre couches de silicium polycristallin.

25. Procédé selon la revendication 24, comprenant en outre l'élimination de ladite couche de photorésist avant de déposer la couche d'oxyde relativement mince pour effet tunnel.

**FIG._1**

**FIG._2**

FLOATING GATE COMPONENT CAPACITANCES
STANDARD INTERPOLY OXIDE

FIG._5a

FLOATING GATE COMPONENT CAPACITANCES
DUAL THICKNESS INTERPOLY OXIDE

FIG._5b

FLOATING GATE READ MEMORY WINDOW
STANDARD INTERPOLY OXIDE

FIG._5c

FLOATING GATE READ MEMORY WINDOW
DUAL THICKNESS INTERPOLY OXIDE

FIG._5d

*FIG._4a*

*FIG._4b*

*FIG._4c*

*FIG._4d*

*FIG._4e*

*FIG._4f*

*FIG._3a*

NO MISALIGNMENT

TUNNELING REGIONS

*FIG._3b*

WITH MISALIGNMENT

ΔL

*FIG._4a*

450    460    410    440    445

*FIG._4b*

460    451    410    440    445

*FIG._4c*

460    452    410    440    445

*FIG._4d*

460    452    411    440    445

*FIG._4e*

452    470    470    440    445

*FIG._4f*

452    420    470    470    440    445

FIG._5a

FLOATING GATE COMPONENT CAPACITANCES
STANDARD INTERPOLY OXIDE

COMPONENT CAPACITANCES
(femtofarads)

20.0

15.0

10.0

5.0

0.0

-0.4   -0.2   0.0   0.2   0.4
POLY2  MISALIGNMENT  (delta L in microns)

516   511   512   513   514   515

FIG._5b

FLOATING GATE COMPONENT CAPACITANCES
DUAL THICKNESS INTERPOLY OXIDE

COMPONENT CAPACITANCES
(femtofarads)

20.0

15.0

10.0

5.0

0.0

-0.4   -0.2   0.0   0.2   0.4
POLY2  MISALIGNMENT  (delta L in microns)

524   523   522   521   525   526

FIG._5c

FLOATING GATE READ MEMORY WINDOW
STANDARD INTERPOLY OXIDE

FLOATING GATE VOLTAGE
(volts)

6.0

4.0

2.0

0.0

-2.0

-4.0

-6.0

-0.4   -0.2   0.0   0.2   0.4
POLY2  MISALIGNMENT  (delta L in microns)

531   533   532   534

FIG._5d

FLOATING GATE READ MEMORY WINDOW
DUAL THICKNESS INTERPOLY OXIDE

FLOATING GATE VOLTAGE
(volts)

6.0

4.0

2.0

0.0

-2.0

-4.0

-6.0

-0.4   -0.2   0.0   0.2   0.4
POLY2  MISALIGNMENT  (delta L in microns)

543   542   544   541